# FASCICULE DE BREVET EUROPEEN

(11) **EP 0 909 342 B1**
(45) Date de publication et mention de la délivrance du brevet: **25.08.2004**
(21) Numéro de dépôt: 97924822.6
(22) Date de dépôt: 09.06.1997
(51) Int. Cl.: C23C 14/56, C23C 14/24

(54) **PROCEDE POUR REVETIR EN CONTINU UN SUBSTRAT EN MOUVEMENT AU MOYEN D'UNE VAPEUR METALLIQUE**
VERFAHREN ZUM KONTINUIERLICHEN BESCHICHTEN EINES SICH BEWEGENDEN SUBSTRATS MIT EINEM METALLDAMPF
METHOD FOR CONTINUOUS COATING OF A MOVING SUBSTRATE BY MEANS OF A METALLIC VAPOUR

(30) Priorité: 13.06.1996 BE 9600542
(43) Date de publication de la demande: 21.04.1999
(73) Titulaire: Centre de Recherches Metallurgiques - Centrum voor de Research in de Metallurgie, 1200 Bruxelles (BE)
(72) Inventeur: COLIN, Robert, B-4100 Boncelles (BE); ECONOMOPOULOS, Marios, B-4020 Liège (BE)
(74) Mandataire: Van Malderen, Michel
(86) Numéro de dépôt international: PCT/BE1997/000066
(87) Numéro de publication internationale: WO 1997/047782

(56) Documents cités:
- WO-A-96/35822
- DE-A- 4 225 169
- FR-A- 1 164 034
- US-A- 4 812 326

## Description

La présente invention a trait à un procédé pour revêtir en continu un substrat en mouvement, plus particulièrement une bande métallique, au moyen d'une vapeur métallique pour former une couche de métal sur sa surface et de la sorte lui conférer une excellente résistance à la corrosion, ainsi que de bonnes caractéristiques d'emboutissabilité et de soudabilité.

Dans la description de l'invention qui suit, on sera amené à faire référence à la fabrication de tôles d'acier revêtues d'un dépôt de zinc, mais il ne s'agit là que d'un exemple d'utilisation, sans aucun caractère restrictif.

On connaît depuis longtemps l'effet bénéfique de différents métaux, tels le zinc ou l'aluminium, pour la protection des bandes d'acier contre la corrosion. Il existe beaucoup de procédés pour réaliser en continu le dépôt d'une couche de zinc ou d'aluminium sur une bande défilant à travers un bain de zinc ou d'aluminium fondu.

Toutefois, s'il est exact que la résistance à la corrosion de la bande d'acier est d'autant meilleure que la couche de protection est épaisse, il n'en subsiste pas moins que, d'une part, le coût de l'opération de revêtement augmente avec l'épaisseur de la couche formée et, d'autre part, qu'une épaisseur trop grande n'est pas toujours nécessaire pour certaines utilisations de la bande d'acier et peut même altérer ses propriétés d'emploi telles la soudabilité ou l'emboutissabilité.

Des considérations précédentes est née l'idée de réaliser des dépôts très minces, de l'ordre de quelques microns, et ce à partir d'une phase vapeur du métal de protection.

On connaît différentes techniques pour réaliser ce type de revêtement, dont certaines appliquées à des substrats en mouvement avec projection d'un mélange de gaz neutre d'entraînement et de vapeur du métal de protection.

Dans ce dernier cas, on sait que la présence de gaz porteur limite les types de métaux ou alliages déposés; en effet, il doit être neutre vis-à-vis de ceux-ci et par ailleurs ne permet pas d'atteindre des rendements élevés, car la densité de vapeur métallique dans le mélange vapeur de métal/gaz inerte d'entraînement est fort faible et limite donc la vitesse de défilement du substrat.

Dans ce même ordre d'idée, certains dispositifs, dans lesquels le substrat défile au-dessus d'un évaporateur à bain métallique, sont eux aussi limités en efficacité, car il se forme une couche de particules de gaz adsorbées à la surface du substrat en mouvement qui empêche la bonne adhérence du dépôt par condensation de la vapeur à basse pression sur ladite surface, d'où la nécessité de travailler avec des vapeurs à basse pression de 3,2 mbars dans des enceintes sous vide de 0,01 mbars, solutions dont le coût devient rapidement prohibitif dans le cadre d'un produit de masse.

En effet, dans les systèmes connus, travaillant dans des enceintes sous vide (0,01 à 0,001 mbars) appelées chambres sous vide principales, qui entourent la chambre de dépôt sous forme de vapeur métallique, cette dernière étant à environ 3,2 mbars, cette différence de pression d'environ 3 mbars entre la chambre de dépôt et l'enceinte sous vide provoque une très forte déperdition de vapeur métallique qui va se déposer sur les parois de la chambre sous vide principale et impose l'arrêt périodique de l'installation pour enlever le métal déposé sur les parois de ladite chambre.

En outre, il faut tenir compte du fait que des pressions de 0,01 à 0,001 mbars dans l'enceinte sous vide imposent la mise en oeuvre de sas d'accès pour le substrat et de pompes à vide en cascade dont les coûts de construction et d'entretien sont loin d'être négligeables.

Le document DE-A-42 25 169 propose un procédé et une installation pour la production de vapeurs sous pression formant des agglomérats allant jusqu'à quelques milliers d'atomes. Les vapeurs sont produites par chauffage dans un évaporateur et injectées à une pression d'au moins 200 hPa (200 mbar) en vue de former une couche mince de revêtement sur un substrat se trouvant dans une chambre à haut vide. La vitesse du jet de vapeur à hauteur du substrat a été estimée à environ 1000 m/s.

Comme mentionné ci-dessus, le différentiel de pression entre la zone de dépôt et le reste de la chambre sous vide provoque d'énormes déperditions de matière sous forme de dépôts sur les parois, ce qui entraîne à la fois un gaspillage de substances pouvant être coûteuses et des coûts importants de nettoyage de la chambre.

La présente invention a été réalisée en partant du savoir-faire déjà divulgué par la Demanderesse. En particulier, la demande internationale WO-A-96 35822 propose un dispositif industriel pour revêtir une bande d'acier, constitué par au moins une cuve d'évaporation sous vide chauffée par induction. La cuve présente un orifice de sortie des vapeurs de métal, se présentant sous la forme d'une fente de petite largeur, située à courte distance du substrat à revêtir. La chambre de dépôt se trouve dans une enceinte sous vide.

Cette demande a été déposée au nom des inventeurs de la présente demande. Elle a pour date de priorité le 10.05.1995 et pour date de publication le 14.11.1996.

Le procédé de revêtement, objet de la présente invention, permet l'obtention d'une couche sur la surface d'un substrat en mouvement à partir d'une phase vapeur, sans présenter les inconvénients précités.

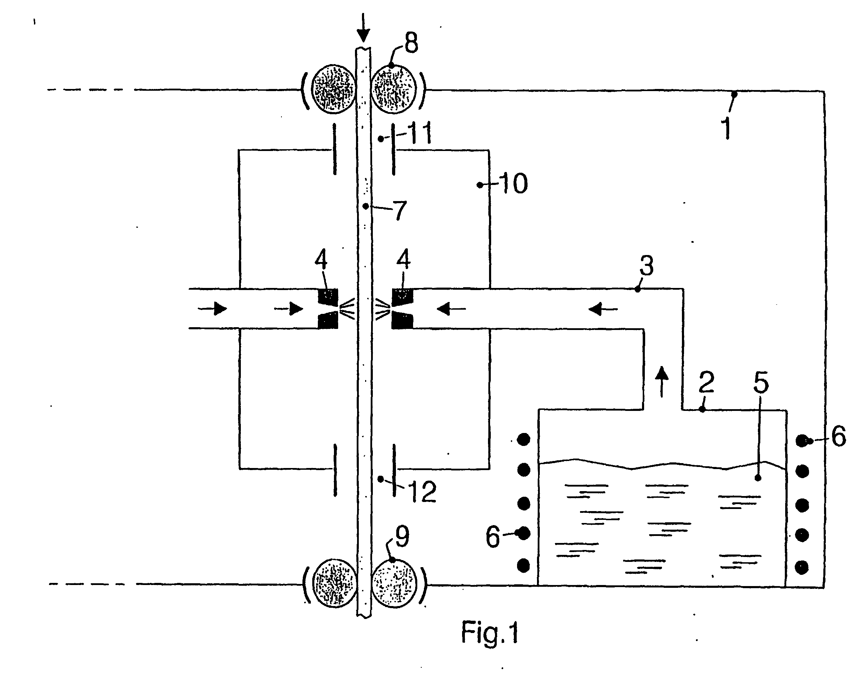

Dans un but de précision et de clarté, on fera référence dans la description de l'invention qui suit à divers éléments représentés sur la figure 1 annexée.

Le procédé de revêtement suivant la présente invention est essentiellement caractérisé en ce qu'un jet constitué de vapeur métallique de métal de revêtement, animé d'une vitesse supérieure à 500 m/s, entre en contact avec la surface du substrat à revêtir.

Le fait que la vapeur métallique entre en contact avec la surface à revêtir à très grande vitesse dans le cadre d'un jet solutionne le problème de destruction de la couche de particules de gaz adsorbées sur la surface précitée et permet l'obtention de revêtements dont l'adhérence est améliorée.

Selon l'invention, on génère la vapeur métallique en chauffant un bain constitué par le métal de revêtement dans une enceinte, hors de laquelle la vapeur ne peut s'échapper que par un conduit qui la dirige vers un orifice de sortie de section limitée, on modifie les conditions régissant la production et l'écoulement de cette vapeur dans l'orifice de sortie de telle sorte que sa vitesse linéaire augmente et on forme un jet dirigé vers la surface du substrat à revêtir.

Suivant une modalité de mise en oeuvre du procédé de la présente invention, on introduit le substrat (7) dans une enceinte appelée chambre à vide (1), la chambre précitée (1) contient au moins une chambre de dépôt (10), la ou les chambres de dépôt précitées étant alimentées en vapeur métallique par au moins une chambre d'évaporation (2) contenant un bain (5) du métal de revêtement et générant via un chauffage approprié la vapeur métallique utilisée pour le revêtement du substrat, la chambre d'évaporation (2) étant reliée à la chambre de dépôt (10) de telle sorte que la surface du substrat (7) soit soumise dans la chambre de dépôt (10) à l'action d'un ou de plusieurs jets de vapeur métallique.

Il va de soi qu'il est possible d'associer plusieurs ensembles comprenant des chambres d'évaporation et de dépôt interconnectées.

Toujours selon l'invention, on régule la quantité de vapeur produite dans la chambre d'évaporation (10) en fonction de la vitesse de défilement du substrat et de l'épaisseur du revêtement à réaliser.

L'apport spécifique de la présente invention à l'état de de la technique est, qu'on régule la température des parois de la chambre de dépôt (10) en fonction de la quantité de vapeur métallique que l'on veut condenser sur les parois précitées.

De plus, en régime stationnaire de l'opération de revêtement, la pression moyenne régnant dans la chambre de dépôt (10) est égale à la pression moyenne régnant dans la chambre à vide (1).

Cette manière de procéder a pour avantage de limiter fortement les pertes de vapeur métallique s'échappant par les orifices (11, 12) de passage du substrat du fait de l'égalité des pressions moyennes entre les chambres à vide (1) et de dépôt (10). Il ne subsiste alors que de très faibles pertes dues à la diffusion et l'entraînement par le substrat via l'orifice de sortie (12).

Suivant une modalité de mise en oeuvre du procédé de l'invention, on refroidit la totalité ou une partie des parois de la chambre de dépôt (10) de manière à condenser une partie de la vapeur métallique présente dans cette chambre de dépôt (10).

La disposition précédente a pour effet de limiter les pertes de vapeur métallique dues à la diffusion, car la pression de vapeur métallique dans la chambre de dépôt est plus basse.

Suivant encore une autre modalité de mise en oeuvre du procédé de l'invention, on chauffe la totalité ou une partie des parois de la chambre de dépôt (10) de manière à supprimer la condensation de la vapeur métallique sur ces dernières.

Il convient de remarquer que, bien que la disposition précédente ait pour effet négatif d'augmenter les pertes par diffusion dues à la pression plus élevée de vapeur métallique dans la chambre de dépôt, il en résulte cependant un effet bénéfique lié à la suppression des arrêts de fonctionnement nécessaires à l'enlèvement des couches solidifiées de vapeur métallique formées sur les parois de la chambre de dépôt.

Suivant une autre modalité de réalisation préférentielle du procédé de l'invention, on régule la température de la totalité ou d'une partie des parois de la chambre de dépôt (10) de telle sorte que la vapeur métallique condensée sur les parois précitées reste à l'état liquide.

Il résulte de la disposition précédente que l'évacuation de la vapeur métallique condensée à l'état liquide peut être faite aisément, par exemple par simple gravitation, vers un dispositif récupérateur qui pourrait être la chambre d'évaporation (2) et ce sans imposer l'arrêt du fonctionnement du procédé de revêtement.

Suivant encore une autre modalité préférentielle de mise en oeuvre du procédé de l'invention, le substrat (7) est une bande d'acier défilant à grande vitesse, de préférence à plus de 100 m/minute.

Suivant une autre modalité de mise en oeuvre de l'invention, on associe en cascade plusieurs chambres de dépôt (10) et on réalise un revêtement multicouches formé de différents métaux ou du même métal.

Suivant encore une autre modalité de mise en oeuvre de l'invention, on réalise un mélange de vapeurs métalliques issues de chambres d'évaporation distinctes et on l'introduit dans une ou plusieurs chambres de dépôt.

Le dispositif pour la mise en oeuvre du procédé de l'invention comporte une chambre à vide (1) formée par une enceinte dotée, d'une part, de moyens (8, 9) permettant l'entrée et la sortie du substrat (7) à revêtir tout en assurant une certaine étanchéité par rapport au milieu extérieur à l'enceinte et, d'autre part, de moyens pour y assurer un état de dépression par rapport au milieu extérieur, l'enceinte précitée (1) englobant une chambre de dépôt (10) dans laquelle passe le substrat (7), cette chambre de dépôt (10) étant reliée à des moyens de génération de vapeur métallique tels qu'une chambre d'évaporation (2) dotée de moyens de régulation de la température du bain métallique (5) y contenu, ainsi que de moyens (3) de collecte de la vapeur métallique, la chambre de dépôt (10) comportant aussi des moyens (4) pour former un jet de vapeur métallique dirigé vers la surface du substrat (7).

Les moyens (4) assurant la formation d'un jet de vapeur métallique comprennent au moins une busette munie d'un orifice de sortie en forme de fente ou d'une série d'orifices cylindriques ou en forme de fentes.

Suivant encore une autre modalité de réalisation du dispositif, celui-ci comporte des moyens pour réguler la température des parois de la chambre de dépôt (10).

Suivant une modalité préférentielle de réalisation du dispositif, les moyens (8,9) d'entrée et de sortie sont formés par des sas à rouleaux cylindriques,

La figure 1, à laquelle il a été fait référence au cours de la description, illustre de manière schématique certains des différents moyens présents dans le dispositif.

On y distingue en (1) l'enceinte formée par la chambre à vide, en (10) la chambre de dépôt et en (2) la chambre d'évaporation contenant le bain (5) et les moyens de chauffage (6).

Le substrat (7) pénètre dans la chambre à vide (1) par le sas (8), puis passe dans la chambre de dépôt (10) via une ouverture (11), il y est soumis à l'opération de revêtement au moyen d'un jet issu des busettes (4) qui sont alimentées en vapeur métallique via (3) à partir de la chambre d'évaporation (2).

Le substrat (7) revêtu quitte la chambre de dépôt (10) via une autre ouverture (12) et la chambre à vide (1) via le sas (9).

A titre d'exemple non limitatif, on notera qu'en travaillant avec un jet de vapeur métallique, dans le cas présent du Zn, animé d'une vitesse d'environ 800 m/s et en maintenant les parois de la chambre de dépôt (10) à une température T_{P} = 500°C, avec une pression moyenne dans la chambre de dépôt (10) et la chambre à vide (1) de 0,3 mbars, dans le cas d'un dépôt d'une couche de revêtement de 10 microns sur les deux faces d'une tôle défilant à 130 m/min, on n'a constaté qu'une perte d'environ 30 kg de zinc par.semaine due d'une part à la diffusion de la vapeur par les orifices de passage (11, 12) de la tôle et d'autre part à l'entraînement de vapeur via l'orifice de sortie (12) dû au mouvement de la tôle.

On constate donc non seulement une amélioration notable des pertes en zinc, 30 kg contre 800 kg mentionnés pour les systèmes connus, mais aussi une simplification des systèmes de pompes et sas pour maintenir une pression de 0,3 mbars au lieu de descendre entre 0,01 à 0,001 mbars nécessaires usuellement dans les systèmes antérieurs pour éviter l'adsorption de particules de gaz sur la surface de la tôle.

Le procédé de l'invention, ainsi que le dispositif y associé, permet de fabriquer un produit revêtu qui présente une résistance accrue à la corrosion, ainsi qu'une très bonne adhérence du revêtement et des qualités d'application (déformabilité, soudabilité) excellentes. De plus, les faibles coûts d'investissement et de fonctionnement du dispositif de l'invention rendent ce produit particulièrement économique.

## Revendications

1. Procédé pour revêtir en continu un substrat en mouvement au moyen d'au moins un jet constitué de vapeur métallique de revêtement, ledit jet de vapeur métallique étant animé d'une vitesse supérieure à 500 m/s, dans lequel :
- la vapeur métallique est générée dans une enceinte appelée chambre à vide (1), ladite chambre à vide (1) comprenant au moins une chambre de dépôt (10) alimentée en vapeur métallique par au moins une chambre d'évaporation (2) contenant un bain (5) du métal de revêtement et générant via un chauffage approprié la vapeur métallique utilisée pour le revêtement dudit substrat, ladite chambre d'évaporation (2) étant reliée à la chambre de dépôt (10) de telle sorte que la surface du substrat (7) soit soumise dans la chambre de dépôt (10) à l'action dudit jet de vapeur métallique ;
- la vapeur métallique ne peut s'échapper de la chambre d'évaporation (2) que par une conduite (3) qui la dirige vers un orifice de sortie (4) de section limitée ;
- les conditions régissant la production et l'écoulement de cette vapeur dans l'orifice de sortie (4) sont modifiées de telle sorte que sa vitesse linéaire augmente et qu'un jet dirigé vers la surface du substrat à revêtir est formé ;
- la quantité de vapeur produite dans la chambre d'évaporation (2) est régulée en fonction de la vitesse de défilement du substrat et de l'épaisseur du revêtement à réaliser ;
**caractérisé en ce que** :
- on régule la température des parois de la chambre de dépôt (10) en fonction de la quantité de vapeur métallique que l'on veut condenser sur les parois précitées et
- on assure en outre dans la chambre à vide (1) un état de dépression de type vide primaire par rapport au milieu extérieur, la pression moyenne régnant dans la chambre de dépôt (10), en régime stationnaire de l'opération de revêtement, étant égale à la pression moyenne correspondant à cette dépression régnant dans ladite chambre à vide (1).

2. Procédé selon la revendication 1, **caractérisé en ce qu'**on refroidit la totalité ou une partie des parois de la chambre de dépôt (10) de manière à condenser une partie de la vapeur métallique présente dans cette chambre de dépôt (10).

3. Procédé selon la revendication 1, **caractérisé en ce qu'**on chauffe la totalité ou une partie des parois de la chambre de dépôt (10) de manière à supprimer la condensation de la vapeur métallique sur ces dernières.

4. Procédé selon la revendication 1, **caractérisé en ce qu'**on régule la température de la totalité ou d'une partie des parois de la chambre de dépôt (10) de telle sorte que la vapeur métallique condensée sur les parois précitées reste à l'état liquide.

5. Procédé selon l'une quelconque des revendications 1 à 4, **caractérisé en ce que** le substrat (7) est une bande d'acier défilant à grande vitesse, de préférence à plus de 100 m/min.

6. Procédé selon l'une quelconque des revendications 1 à 5, **caractérisé en ce qu'**on associe en cascade plusieurs chambres de dépôt (10) et **en ce qu'**on réalise un revêtement multicouches formé de différents métaux ou du même métal.

7. Procédé selon l'une quelconque des revendications 1 à 6, **caractérisé en ce qu'**on réalise un mélange de vapeurs métalliques issues de chambres d'évaporation distinctes et **en ce qu'**on l'introduit dans une ou plusieurs chambres de dépôt.

## Patentansprüche

1. Verfahren zur kontinuierlichen Beschichtung eines sich bewegenden Trägermaterials mit Hilfe von mindestens einem Strahl zur Beschichtung, der aus Metalldampf besteht. Der besagte Strahl aus Metalldampf wird auf eine Geschwindigkeit von mehr als 500 m/s beschleunigt, bei welchem
- Der Metalldampf wird in einem Schutzgehäuse erzeugt, das Vakuumkammer (1) genannt wird. Diese Vakuumkammer (1) ümfasst mindestens eine Anlagerungskammer (10), die von mindestens einer Verdampfungskammer (2) gespeist wird. Die Verdampfungskammer enthält ein Bad (5) des Beschichtungsmetalls und erzeugt über eine geeignete Erhitzung den Metalldampf, der für eine Beschichtung des besagten Trägermaterials verwendet wird. Die besagte Verdampfungskammer (2) ist mit der Anlagerungskammer (10) derart verbunden, dass die Oberfläche des Trägermaterials in der Anlagerungskammer (10) der Wirkung des besagten Metalldampf-Strahls ausgesetzt wird.
- Der Metalldampf kann aus der Verdampfungskammer (2) nur durch eine Leitung (3) austreten, die den Dampf zu einer Ausgangsöffnung (4) mit begrenztem Querschnitt führt.
- Die Bedingungen, die die Produktion und das Ausströmen dieses Dampfes in die Ausgangsöffnung (4) steuern, werden derart verändert, dass seine lineare Geschwindigkeit ansteigt und dass ein Strahl, der auf die Oberfläche des zu beschichtenden Trägermaterials gerichtet ist, gebildet wird.
- Die Menge des in der Verdampfungskammer (2) erzeugten Dampfes wird in Abhängigkeit der Geschwindigkeit erzeugt, in der das Trägermaterial vorbeigeführt wird, sowie abhängig von der zu erzeugenden Dicke der Beschichtung;
**dadurch gekennzeichnet, dass**:
- Die Temperatur der Wände der Anlagerungskammer (10) in Abhängigkeit der Menge des Metalldampfes geregelt wird, der auf den vorgenannten Wänden kondensieren soll.
- Man stellt ferner sicher, dass in der Vakuumkammer (1) ein Unterdruckzustand der Art Primärvakuum im Vergleich zu der Außenumgebung herrscht. Der mittlere Druck, der in der Anlagerungskammer (10) herrscht, ist bei stationärer Steuerung während des Beschichtungsvorgangs gleich dem mittleren Druck, der diesem Unterdruck in besagter Vakuumkammer (1) entspricht.

2. Verfahren gemäß Anspruch 1, **dadurch gekennzeichnet, dass** sämtliche oder ein Teil der Wände der Anlagerungskammer (10) in einer Weise gekühlt wird/werden, so dass ein Teil des Metalldampfes, der in dieser Anlagerungskammer (10) vorhanden ist, hier kondensiert.

3. Verfahren gemäß Anspruch 1, **dadurch gekennzeichnet, dass** sämtliche oder ein Teil der Wände der Anlagerungskammer (10) in einer Weise erwärmt wird/werden, dass die Kondensation von Metalldampf auf diesen Wänden unterdrückt wird.

4. Verfahren gemäß Anspruch 1, **dadurch gekennzeichnet, dass** man die Temperatur der Wände der Anlagerungskammer (10) in einer Weise regelt, dass der auf diesen wänden kondensierende Metalldampf in flüssigem Zustand bleibt.

5. Verfahren gemäß dem einen oder anderen der Ansprüche 1 bis 4, **dadurch gekennzeichnet, dass** es sich bei dem Trägermaterial (7) um einen Stahlstreifen handelt, der mit hoher Geschwindigkeit (an der/den Düse(n), Zusatz. d. Übers.) vorbeigeführt wird, vorzugsweise mit einer Geschwindigkeit von mehr als 100 m/min.

6. Verfahren gemäß dem einen oder anderen der Ansprüche 1 bis 5, **dadurch gekennzeichnet, dass** mehrere Anlagerungskammern (10) kaskadierend miteinander verbunden werden, so dass man hierdurch eine Beschichtung aus mehreren Schichten erhält, die aus verschiedenen Metallen oder dem gleichen Metall besteht.

7. Das Verfahren gemäß dem einen oder anderen der Ansprüche 1 bis 6, **dadurch gekennzeichnet, dass** man ein Gemisch der aus den einzelnen Verdampfungskammern abgegebenen Metalldämpfe erzielt und diesen in eine oder mehrere Anlagerungskammern einführt.

## Claims

1. A method for the continuous coating of a moving substrate by means of at least one jet consisting of a metallic coating vapour, said jet of vapour being propelled at a speed higher than 500 m/s, in which:
- the metallic vapour is generated in an enclosure called the vacuum chamber (1), said vacuum chamber (1) comprising at least one deposition chamber (10) supplied with metallic vapour by at least one evaporation chamber (2) containing a bath (5) of the coating metal and generating by means of suitable heating the metallic vapour used for the coating of said substrate, said evaporation chamber (2) being connected to the deposition chamber (10) in such a way that the surface of the substrate (7) is subjected to the action of said metallic vapour jet in the deposition chamber (10);
- the metallic vapour can only escape from the evaporation chamber (2) by a duct (3) which directs it towards an outlet opening (4) of limited width;
- the conditions governing the production and flow of this vapour in the outlet opening (4) are adjusted so that its linear velocity increases and a jet directed at the surface of the substrate to be coated is formed;
- the quantity of vapour produced in the evaporation chamber (2) is adjusted relative to the motion speed of the substrate and to the thickness of the coating to be achieved;
**characterised in that**:
- the temperature of the walls of the deposition chamber (10) is adjusted depending on the quantity of metallic vapour to be condensed on said walls and
- a state of low pressure of a primary vacuum type relative to the external environment is moreover ensured in the vacuum chamber (1), the average pressure obtained in the deposition chamber (10), in conditions of a constant coating operation, being equal to the average pressure corresponding to this low pressure obtained in said vacuum chamber (1).

2. Method as in Claim 1, **characterised in that** the whole or a part of the walls of the deposition chamber (10) are cooled in such a way as to condense part of the metallic vapour present in this deposition chamber (10).

3. Method as in Claim 1, **characterised in that** the whole or a part of the walls of the deposition chamber (10) is heated in such a way as to remove the condensation of the metallic vapour on the latter.

4. Method as in Claim 1, **characterised in that** the temperature of the whole or a part of the walls of the deposition chamber (10) is adjusted so that the metallic vapour condensed on said walls remains in a liquid state.

5. Method as in any one of Claims 1 to 4, **characterised in that** the substrate (7) is a sheet of steel passing through at high speed, preferably at more than 100m/min.

6. Method as in any one of Claims 1 to 5, **characterised in that** several deposition chambers (10) are associated in series and **in that** a multi-layer coating made of several different metals or of the same metal is produced.

7. Method as in any one of claims 1 to 6, **characterised in that** a mixture of metallic vapours coming from different evaporation chambers is produced and **in that** it is introduced into one or several deposition chambers.
